# EUROPÄISCHE PATENTSCHRIFT

(11) **EP 2 196 856 B1**
(45) Veröffentlichungstag und Bekanntmachung des Hinweises auf die Patenterteilung: **16.10.2013**
(21) Anmeldenummer: 08405301.6
(22) Anmeldetag: 09.12.2008
(51) Int. Cl.: B41C 1/05, B41C 1/10, G03F 7/20

(54) **System zum Übertragen von Daten und dessen Verwendung**
System for transmitting data and its application
Système de transmission de données et son utilisation

(43) Veröffentlichungstag der Anmeldung: 16.06.2010
(73) Patentinhaber: XPOSE Holding AG, 5014 Gretzenbach (CH)
(72) Erfinder: Berner, Peter, 5102 Rupperswil (CH)
(74) Vertreter: EGLI-EUROPEAN PATENT ATTORNEYS

(56) Entgegenhaltungen:
- WO-A-00/76202
- WO-A-98/52345
- DE-A1- 19 926 479
- GB-A- 2 314 991
- NL-A- 8 501 101
- US-A1- 2004 017 622

## Beschreibung

Die Erfindung betrifft ein System und ein Verfahren zum Übertragen von Daten auf plattenförmige Datenträger sowie die bevorzugte Verwendung dieses Systems, insbesondere zur Belichtung von Druckplatten, Flexoplatten, Siebdruckschablonen oder Buchdruckplatten.

In der Druckindustrie werden oft verschiedene Druckverfahren wie z.B. Siebdruck, Flexodruck, Buchdruck usw. kombiniert. Dabei wird grundsätzlich zwischen dem analogen und dem digitalen Belichten von Druckplatten unterschieden. Die auf einem Negativ- bzw. Positivfilm enthaltenen Daten, wie z.B. Bilder, Schriften oder Grafiken werden in einem Kopierraum oder einer Repetierkopiermaschine mittels einer Ultraviolett-Lichtquelle - in analoger Art und Weise - auf eine lichtempfindliche Druckplatte übertragen. Der Lichtquelle angepasst ist die Eigenschaft der lichtempfindlichen Schicht der Druckplatte, so dass sie z.B. bei 380 nm ein Empfindlichkeitsmaximum aufweist.

Der Bildbereich einer Druckplatte wird von einem oder mehreren Lasern - in digitaler Art und Weise - direkt beschrieben. Die Empfindlichkeit der Druckplatte weist dabei ein Maximumentsprechend der Lichtquelle auf. Je nach der Wellenlänge des eingesetzten Lichtes spricht man bei sichtbarem Licht von konventionellen Offsetplatten und bei InfrarotLicht mit z.B. 830 nm von Thermoplatten.

Zum Übertragen von Daten, wie z.B. Bildern, Schriften oder Grafiken, auf Datenträger wie z.B. Offset-Druckplatten sind im Wesentlichen drei Belichtungsprinzipien bekannt.

Das Flachbett, als einfachstes System zum analogen Belichten von Druckplatten eignet sich nur bedingt zum digitalen Belichten derselben. Einerseits wächst der Aufwand der Führung eines Belichtungskopfes mit der Grösse der Druckplatte, andererseits bleibt durch die verlangte Belichtungsgeschwindigkeit immer ein Teil des möglichen Verfahrweges des Belichtungssystems, wegen der notwendigen Anfahr- und Bremsrampen des Belichtungskopfes, ungenutzt.

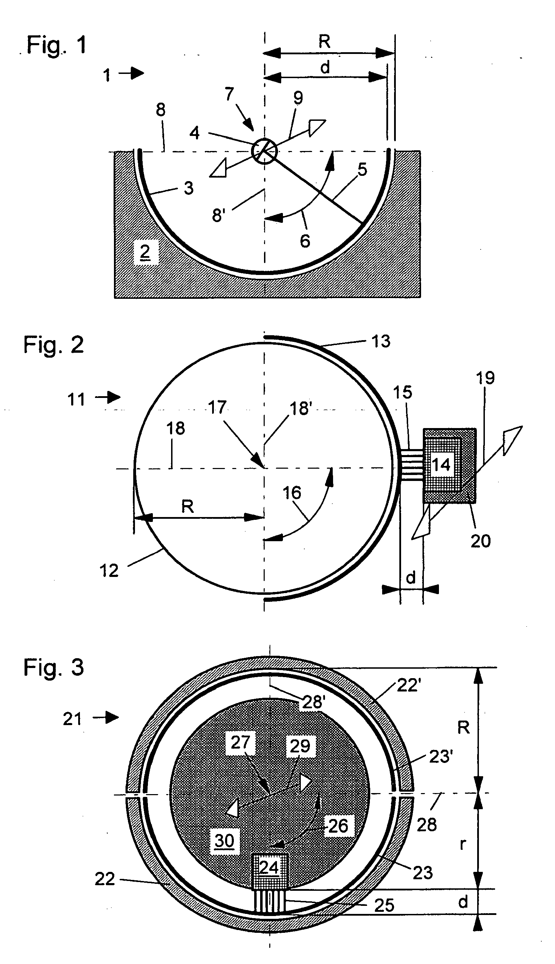

Ein an sich bekannter Innentrommelbelichter (siehe Fig. 1) weist die Vorteile auf, dass die Plattengrösse unabhängig gewählt werden kann, da sich die Platte beim Belichten nicht bewegt. Die Platten lassen sich einfach in vorgesehene Passlöcher legen. Ein automatisches System zum Zu- und Wegführen der Platten lässt sich relativ einfach bewerkstelligen. Als Nachteile eines solchen Innentrommelbelichters müssen angeführt werden, dass mit einem besonders starken, frequenzverdoppelten YAG-Laser gearbeitet werden muss, wobei man aus dem Zentrum der Trommel einen einzigen Laserstrahl über die Platte rotieren lässt. Dies erschwert die Fokussierung wegen des grossen Abstandes und lässt kein Belichten mit Mehrfachstrahlen zu. Verwendet wird oft ein Polygonspiegel, der mit bis zu 30'000 U/min gedreht wird. Dies erfordert eine aufwändige Lagerung. Zudem wirken sich Vibrationen - sei es in der Umgebung des Gerätes oder innerhalb des Systems - extrem auf die erreichbare Auflösung auf.

Bei einem ebenfalls bekannten Aussentrommelbelichter (siehe Fig. 2) kann der Belichtungskopf bis auf wenige Millimeter an die Platte herangeführt werden, was den Einsatz wesentlich schwächerer und preiswerterer Laserdioden erlaubt.

Diese lassen sich leichter fokussieren und als Mehrfachköpfe addieren, wobei Vorrichtungen mit wahlweise 256 oder 512 nebeneinander angeordneten Laserdioden bekannt sind. Diesen Vorteilen stehen folgende Nachteile gegenüber, dass das sichere Festhalten der Platte auf der Trommel konstruktiv sehr aufwendig ist. Ein unerwünschtes Ablösen der Platte während dem Belichten kann nicht ausgeschlossen werden. Sollt sich dies aber ereignen, so muss mit erheblichen Schäden an der Maschine, insbesondere am Belichtungskopf, gerechnet werden.

Die Drehzahl der Trommel ist auf ca. 100 U/min limitiert, womit sich eine Vergrösserung der zu belichtenden Fläche in wesentlichem Masse auf die Belichtungszeit auswirkt. Verschiedene Plattenformate ergeben eine unterschiedliche Gewichtsverteilung auf der Trommel, woraus sich im Routinebetrieb die Notwendigkeit eines automatischen Auswuchtens ergibt. Ein sicheres Einlegen der Platten in die Registerstifte ist sehr aufwendig, was die Automation dieses Vorganges einerseits praktisch erfordert, andererseits hingegen erheblich erschwert.

Weder das Innen- noch das Aussentrommelsystem lassen eine Belichtung mehrere verschiedener Materialien zu, da sie lediglich Licht einer Wellenlänge zur Verfügung stellen. Dies schränkt die Verwendbarkeit der Maschinen deutlich ein, insbesondere für Druckereien, die verschiedenartige Druckplatten wie Flexoplatten, Offsetplatten Buchdruckplatten oder Siebdruckschablonen benötigen. Derartige Druckereien benötigen besonders vielseitig einsetzbare Systeme für verschiedene Anwendungen.

Die Aufgabe der vorliegenden Erfindung besteht darin, ein Belichtungssystem vorzuschlagen, welches besonders flexibel einsetzbar, konstruktiv einfach aufgebaut, wartungsfreundlich und schnell ist, und dabei auch noch kostengünstig hergestellt werden kann. Zudem soll es viele der individuellen Vorteile der bekannten Innen- und Aussentrommelbelichter kombinieren und eine beträchtliche Zahl der Nachteile dieser Systeme eliminieren.

Diese Aufgabe wird durch ein System nach Anspruch 1 gelöst.

Ein wesentlicher Punkt des erfindungsgemässen Systems besteht darin, dass nunmehr unterschiedlichste Materialien auf ein und derselben Maschine belichtet werden können und diese damit eine erhebliche Flexibilität aufweist. Ein solches System soll im folgenden auch als hybrides system bezeichnet werden. Dies wird zum einen durch die Verwendung von Arrays aus Lichtquellen möglich, die weniger Platz erfordern als eine einzige starke Lichtquelle. Erst dadurch lässt sich eine Mehrzahl von Übertragungsmitteln in ein Innentrommelsystem integrieren, die dann bestimmte Wellenlängen bereitstellen. Die Arrays aus Lichtquellen erlauben zudem eine schnelle Datenübertragung in Mehrstrahltechnik. Zum anderen trägt die klare Aufteilung der Wellenlängen auf die einzelnen Übertragungsmittel zu deren modularen und kompakten Aufbau bei. Denn jedes Übertragungsmittel muss konstruktiv nur auf einen verwendeten Typ von Lichtquelle wie z.B. LED oder Laser-Diode abgestimmt sein. Dadurch sind die einzelnen Übertragungsmittel auch besonders einfach austauschbar, so dass das System mit wenig Aufwand gewartet bzw. umkonfiguriert werden kann.

Bevorzugte Weiterbildungen des Systems bzw. bevorzugte Verwendungen desselben ergeben sich aus den jeweiligen abhängigen Ansprüchen.

In einer bevorzugten Weiterbildung ist dabei vorgesehen, dass die wenigstens zwei Übertragungsmittel zum Erzeugen von Licht der Wellenlängen 375 nm und/oder 405 nm und/oder 830 nm und/oder 904 nm ausgelegt sind. Mit zwei oder mehr dieser erfindungsgemäss in einem einzigen Belichtungssystem integrierten Wellenlängen ist eine flexible Bearbeitung von Materialien z.B. im Siebdruck oder Offsetdruck mit konventionellen Platten (375 nm, 405 nm) wie auch im Offset-Bereich mit Thermoplatten (405 nm, 830 nm) möglich. Im Siebdruckbereich lassen sich z.B. sowohl konventionelle Platten wie auch industriell hergestellte und vorbeschichtete Siebdruckschablonen mit hoher Druckgenauigkeit für anspruchsvolle Siebdruckanwendungen (Screens, Gallus™) bearbeiten. Der Vorteil besteht in einer einfachen und wirtschaftlichen Herstellung, in der genauen und reproduzierbaren Datenübertragung, sowie in der hohen Auflösung und Randschärfe. Dabei können z.B. Karbonbeschichtete Platten, prozesslose Platten (Antem Presstek™), Toyobo™-Platten und MacDermid™-Patten bearbeitet werden. Schon die zwei Wellenlängen von 405 nm und 830 nm ermöglichen damit eine bereits erhebliche Flexibilität in der Druckformerzeugung auf einer einzigen Maschine.

Der Einsatz unterschiedlicher Wellenlängen verlangt allerdings eine jeweils auf die gerade verwendete Wellenlänge angepasste Fokussierungsoptik. Um diese Optik nicht immer wieder wechseln zu müssen ist es von Vorteil, dass eine einzige Optik zum Fokussieren der Arrays von Lichtquellen auf den Datenträger vorgesehen ist, welche auf das Licht unterschiedlicher Wellenlängen anpassbar ist. Damit entfällt ein konstruktiv aufwändiger Wechselmechanismus, der eine stets aufs Neue genaue Justierung der Optik erfordert, und der zudem verschleissanfällig und damit wartungsintensiv ist.

Bevorzugt weist die Optik dazu eine funktionale Oberflächenbeschichtung wie ein Spiegelelement mit elektromechanisch verformbarer Oberfläche auf, das auch als Wellenfrontmodulator (Digital Light Processor, DLP) bekannt ist. Das Substratmaterial eines derart verformbaren Spiegels besteht typischerweise aus einer nur wenige Mikrometer starken und einen Quadratzentimeter grossen geätzten Siliziumfolie, auf die eine Metallschicht und mehrere Schichten Dielektrika aufgebracht sind. Das Dielektrikum erhöht mit der Reflektivität auch die Zerstörungsschwelle. Die Spiegel werden mit Hilfe von piezoelektrischen Aktoren mit Arbeitsfrequenzen von mehreren Kilohertz verformt.

Alternativ dazu kann aber auch vorgesehen sein, dass die Optik ein sphärisch verformbares Linsenelement aufweist. Eine solche Linse mit variabler Brennweite basiert z.B. auf einer in dem Linsenkörper gekapselten Polymerflüssigkeit. Der Linsenkörper selbst kann von einem polierten und antireflexbeschichteten Substrat auf der einen Seite und einer elastischen Membran auf der anderen Seite. Durch Drehen eines Ringes am Gehäuse der Linse wird Flüssigkeit aus einem Reservoir in den Linsenkörper gedrückt, wodurch sich die Membran sphärisch deformiert und damit die Brennweite der Linse ändert. Diese Technologie zeichnet sich durch günstige Kosten bei gleichzeitig hoher Flexibilität, Qualität und Präzision aus.

Es kann aber auch vorgesehen sein, dass die Optik ein Linsenelement mit wellenlängenadaptiver Beschichtung aufweist. Zum Beispiel können dünne filmartige Beschichtungen zur Reflexionsvergrößerung bzw. -verkleinerung der Oberfläche einer optischen Komponente verwendet werden. Diese können zur Leistungssteigerung bei einer bestimmten Wellenlänge bzw. über ein breites Band an Wellenlängen dienen.

Eine besonders einfache Umstellung der Wellenlängen ist dann möglich, wenn die Steuereinheit wellenlängenabhängige Parametersätze zum automatischen Einstellen des Belichtungssystems auf eine gewünschte Wellenlänge umfasst. Wird eine andere Wellenlänge gewünscht, kann dann der eine oder der andere wellenlängenabhängige Parametersatz sozusagen auf Knopfdruck aktiviert werden, so dass eine aufwändige Neueinstellung des Belichtungssystems entfällt. Für die Umstellbarkeit des Systems auf einen hybriden Betrieb kann ebenfalls ein entsprechender Parameter vorgesehen sein. So kann ein und dieselbe Software auf normalen, d.h. einwelligen, und zugleich auf hybriden, d.h. mehrwelligen Systemen genutzt werden.

Bevorzugt umfassen die Parametersätze wenigstens Betriebsparameter der Lichtquellen und/oder des Übertragungskopfs und/oder der Übertragungsmittel und/oder der Optik. Damit sind alle Systemkomponenten optimal auf die neue Wellenlänge einstellbar. Betriebsparameter können insbesondere optische, elektrische und mechanische Kenngrössen des Systems umfassen, die wellenlängenabhängig umzuschalten sind. Dazu gehören Einstellungen wie z.B. Schrittweiten-Offset (fractional stagger offset), Mehrfachabtastung (multiscan), Laser-Ruhestrom (laser bias current), Lasermodultyp (laser module type), erstes und letztes Lasermodul (first and last laser module), erster und letzter aktiver Laser (first and last active laser), Lasertyp (laser type), maximaler Laserstrom (maximum laser current), Laser-Leistungsabgabe (laser output power), Laser-Leistungstoleranz (laser power tolerance), maximale Laser-Leistungstoleranz (maximum laser power tolerance), Laser-Schwellwert (laser threshold), Digitalpotentiometer für Lasersensor (digital potentiometer for laser sensor), maximaler Laser-Durchschnittsstrom (maximum mean laser current), Fokussierungseinstellung für Referenzposition (reference position focus adjustment), Plattenpositionserkennung (plate position detection) usw.

Die Parametersätze können dabei auch wellenlängenabhängige Betriebsparameter für einen elektrischen Linearmotor umfassen, der bevorzugt zum Bewegen des Übertragungskopfs und/oder des Aufnehmers vorgesehen ist. Ein solcher Linearmotor erlaubt zum einen die besonders genaue und schnelle axiale Positionierung des Übertragungskopfs in der Trommel. Zum anderen ist die Geschwindigkeit dieses Motors auch über einen weiten Geschwindigkeitsbereich hinweg besonders exakt einstellbar. Dies ist notwendig, da die Bearbeitung unterschiedlicher Materialien nicht nur unterschiedliche Wellenlängen erfordert. Sie erfordert auch eine gleichermassen angepasste Dreh- und Axialgeschwindigkeit des Übertragungskopfs.

Eine ausgewogene Massenverteilung in dem Übertragungskopf des Belichtungssystems wird bevorzugt dadurch erreicht, indem die Lichtquellen durch Enden von Lichtleitern gebildet sind, welche mit je einer Laserdiode zusammenwirken. Dadurch können die Laserdioden getrennt von den Lichtquellen in dem Übertragungskopf angeordnet werden. Eine Unwucht des Kopfes mit der Folge von Ungenauigkeiten und erhöhtem Stabilisierungsaufwand werden so vermieden und gleichzeitig wird der zur Verfügung stehende Bauraum besser genutzt.

Eine besonders gute Montier- und Wartbarkeit wird dadurch erzielt, indem die Laserdioden und/oder die Übertragungsmittel Anschlüsse zur lösbaren Verbindung der einzelnen Lichtleiter aufweisen.

Dazu ist in bevorzugter Weise vorgesehen, dass die Übertragungsmittel eine jeweilige Verbindungsplatte mit rasterförmig darauf angeordneten Anschlüssen aufweisen, die besonders gut zugänglich sind.

Die vorstehenden Aufgabe wird auch durch ein Verfahren zum Übertragen von Daten unter Verwendung des erfindungsgemässen Systems gelöst, bei dem die Daten in Mehrstrahltechnik auf einen Datenträger übertragen werden, und abhängig von einer jeweils geforderten Wellenlänge des Lichts jeweils andere Lichtquellen ein- bzw. ausgeschaltet werden.

Dabei ist es insbesondere bevorzugt, wenn abhängig von einer jeweils gewünschten Wellenlänge eine automatische Einstellung des Systems über dazu hinterlegte Parametersätze vorgenommen wird, um eine weitgehende Automatisierung der Umstellung zu ermöglichen.

Besonders bevorzugt werden dabei Betriebsparametern der Lichtquellen und/oder des Übertragungskopfs und/oder der Übertragungsmittel und/oder der Optik vorgenommen, um eine umfassende und genaue Einstellung des Systems zu gewährleisten.

Das erfindungsgemässe System und das erfindungsgemässe Verfahren sollen bevorzugt dazu verwendet werden, eine Druckplatte, eine Flexoplatte, eine Siebdruckschablone oder eine Buchdruckplatte zu belichten.

Die erfindungsgemässe Vorrichtung wird im folgenden anhand von schematischen Zeichnungen diskutiert. Diese stellen lediglich eine bevorzugte Ausführungsform der Erfindung dar und sollen den Umfang dieser Erfindung keinesfalls einschränken. Es zeigen:
- Fig. 1: einen Querschnitt durch ein Innentrommelbelichtungssystem (Stand der Technik);
- Fig. 2: einen Querschnitt durch ein Aussentrommelbelichtungssystem (Stand der Technik);
- Fig. 3: einen Querschnitt durch ein erfindungsgemässes Innentrommelbelichtungssystem, und
- Fig. 4: eine perspektivische Ansicht von zwei Übertragungsmitteln und einer Optik in einem erfindungsgemässen Innentrommelbelichtungssystem.

Fig. 1 zeigt ein an sich bekanntes Innentrommelbelichtungssystem 1 mit einem Aufnehmer 2 in zumindest teilweiser Zylinderform. In diesen Aufnehmer eingelegt ist eine Druckplatte 3, vorzugsweise eine Thermodruckplatte. Mittels eines rotierenden Übertragungsmittels 4, eines Prismas, wird ein Lichtstrahl 5 auf die Oberfläche der Druckplatte 3 gesandt.

Das Prisma 4 ist in der Richtung 6 um die Zylinderachse 7, welche durch die Schnittlinie der Symmetrieebenen 8 bzw. 8' verläuft, rotierbar. Dadurch kann z.B. die ganze Breite der Druckplatte 3 mit dem Lichtstrahl bzw. Laserstrahl 5 überstrichen werden. Damit eine möglichst grosse Fläche der Platte 3 durch den Laserstrahl 5 getroffen werden kann, wird das Prisma in diesem Beispiel entlang der Zylinderachse 7 in der Richtung 9 bewegt. Die Platte 3 kann beispielsweise mittels Unterdruck im Aufnehmer 2 festgehalten werden, so dass die Platte ebenfalls eine im Wesentlichen zylindrische bzw. teilzylindrische Form einnimmt. So wird erreicht, dass diejenige Seite der Platte 3, auf welche Daten übertragen werden sollen, um einen praktisch konstanten Wert d vom Drehzentrum des Prismas 4 bzw. von der Zylinderachse 7 beabstandet ist. Entsprechend der verhältnismässig geringen Dicke der Platte 3 ist der Belichtungsabstand d fast gleich gross wie der Radius R des zylinderförmigen Aufnehmers 2 bzw. der Innentrommel.

Fig. 2 zeigt ein an sich bekanntes Aussentrommelbelichtungssystem 11 mit einem Aufnehmer 12 in zumindest teilweiser Zylinderform. Auf diesen Aufnehmer gelegt ist eine Druckplatte 13, vorzugsweise eine Thermodruckplatte. Mittels

Übertragungsmitteln 14, welche Laserdioden umfassen, welche an einem Übertragungskopf 20 befestigt sind, werden Lichtstrahlen 15 auf die Oberfläche der Druckplatte 13 gesandt. Der Übertragungskopf 20 ist in der Richtung 17 entlang der Zylinderachse 19, welche durch die Schnittlinie der Symmetrieebenen 18 bzw. 18' verläuft, bewegbar. Dadurch kann z.B. die ganze Länge der Druckplatte 3 mit den Lichtstrahlen bzw. Laserstrahlen 15 überstrichen werden. Damit eine möglichst grosse Fläche der Platte 13 durch die Laserstrahlen 15 getroffen werden kann, ist der Aufnehmer bzw. die Aussentrommel 12 in diesem Beispiel um ihre Zylinderachse 17 in der Richtung 19 rotierbar. Die Platte 13 kann beispielsweise mittels Unterdruck und/ oder Klammern am Aufnehmer 12 festgehalten werden, so dass die Platte ebenfalls eine im Wesentlichen zylindrische bzw. teilzylindrische Form einnimmt. So wird erreicht, dass diejenige Seite der Platte 13, auf welche Daten übertragen werden sollen, um einen praktisch konstanten Wert d von der Oberfläche der Übertragungsmittel 14 bzw. vom Übertragungskopf 20 beabstandet ist. Entsprechend dem verhältnismässig grossen Durchmesser der Aussentrommel 12 ist der Belichtungsabstand d viel kleiner als der Radius R des zylinderförmigen Aufnehmers 12 bzw. der Aussentrommel.

Fig. 3 zeigt in einer schematisierten Querschnittsdarstellung ein erfindungsgemässes Innentrommelbelichtungssystem 21. In den Aufnehmer bzw. in die Trommel 22 ist eine Druckplatte 23, vorteilhafterweise eine Thermoplatte, eingelegt. Mittels eines Übertragungsmittels 24, welches Laserdioden umfasst und an einem Übertragungskopf 30 angeordnet sind, werden Lichtstrahlen 25 auf die Oberfläche der Druckplatte 23 gesandt. Das Übertragungsmittel umfasst ein Array, d.h. eine regelmässige Anordnung von 24 bis 256 Lichtquellen. Der Übertragungskopf 30 ist als Scheibe ausgebildet und in der Richtung 26 um die Zylinderachse 29, welche durch die Schnittlinie der Symmetrieebenen 28 bzw. 28' verläuft, rotierbar. Dadurch kann z.B. die ganze Breite der Druckplatte 23 mit den Lichtstrahlen bzw. Laserstrahlen 25 überstrichen werden. Der Übertragungskopf 30 ist zusätzlich in der Richtung 29 um die Zylinderachse 27, welche durch die Schnittlinie der Symmetrieebenen 28 bzw. 28' verläuft, bewegbar. Dadurch kann z.B. auch die ganze Länge der Druckplatte 23 mit den Lichtstrahlen bzw. Laserstrahlen 25 überstrichen werden. Die Platte 23 kann beispielsweise mittels Unterdruck im Aufnehmer 22 festgehalten werden, so dass die Platte ebenfalls eine im Wesentlichen zylindrische bzw. teilzylindrische Form einnimmt.

So wird erreicht, dass diejenige Seite der Platte 23, auf welche Daten übertragen werden sollen, um einen praktisch konstanten Wert d von zumindest einer Oberfläche des Übertragungsmittels 24 bzw. des Übertragungskopfes 30 beabstandet ist. Entsprechend dem verhältnismässig grossen Durchmesser der Innentrommel 22 ist der Belichtungsabstand d viel kleiner als der Radius R des zylinderförmigen Aufnehmers 22 bzw. der Innentrommel. Erfindungsgemäss wird der Radius r des Übertragungskopfes 30 so gewählt, dass gilt: r > R/2.

Damit wird erreicht, dass der Übertragungskopf 30 möglichst weit an die eingelegte, zu belichtende Platte 23 angenähert wird. Vorzugsweise beträgt der Belichtungsabstand d weniger als 1 cm.

Der Übertragungskopf 30 ist in Fig. 3 als massive Vorrichtung gezeichnet, es kann aber auch vorgesehen werden, dass eines oder mehrere der Übertragungsmittel 24 so verschiebbar abgeordnet sind, dass der Abstand r zwischen einer Oberfläche der Übertragungsmittel 24 und der Zylinderachse 27 variierbar ist. Auch kann die Form des Übertragungskopfes von - derjenigen einer Scheibe abweichen, vorteilhaft ist jedoch immer, dass ein Auswuchten des Übertragungskopfes 30 möglich ist.

In einer Variante dieser Ausführungsform kann vorgesehen werden, dass der Aufnehmer bzw. die Innentrommel zwei Teilschalen 22 bzw. 22' umfasst. So kann die Innentrommel bis zu ihrem ganzen Umfang mit Laserlicht oder anderen zum Übertragen von Daten verwendeten Medien bzw. Strahlen bestrichen werden. Besonders geeignet sind dabei die gezeigten Halbschalen 22 bzw. 22', von denen eine oder beide auch ausserhalb des Datenübertragungssystems 21 mit einer Druckplatte 23 bzw. 23' beschickt werden können. Auf diese Art kann die Zeit zum Beschicken des Systems zusätzlich verkürzt werden.

Anstelle des Unterdruckes zum Halten der Druckplatten werden auch andere Verfahren, wie z.B. die statische Aufladung von Platten 23 bzw. 23' und/oder Aufnehmer 22 bzw. 22' vorgeschlagen.
Wichtig ist, dass beim Übertragen von Daten die Übertragungsmittel 24 und die Oberfläche der zu belichtenden Druckplatte 23 so relativ zueinander bewegbar sind, dass der Belichtungsabstand d möglichst klein ist. Deshalb werden im folgenden weitere bevorzugte Ausführungsformen der Erfindung dahingehend formuliert, dass der Übertragungskopf 30 um die Zylinderachse 27 rotiert und die Innentrommel 22 entlang dieser Zylinderachse bewegbar ist; dass der Übertragungskopf 30 entlang der Zylinderachse 27 bewegbar ist und die Innentrommel um diese Zylinderachse rotiert; dass der Übertragungskopf 30 fixiert ist und die Innentrommel 22 sowohl entlang der Zylinderachse 27 bewegbar als auch um diese Zylinderachse rotiert, womit der Übertragungskopf an irgend einem Punkt des Übertragungssystems 21, beispielsweise an einer senkrecht zur Zylinderachse stehenden Ebene - allenfalls verschiebbar - auf einer Seite des Zylinders befestigt werden kann. Die Form eines solchen Übertragungskopfes kann von der einer runden Scheibe abweichen, weil nicht auf eine Auswuchtung geachtet werden muss. Ein solcher Übertragungskopf 30 bzw. die Übertragungsmittel 24 können auch nichtzentrisch irgendwo im Inneren des zylindrischen oder teilzylindrischen Aufnehmers 22 angeordnet werden.

Eine Möglichkeit zur radialen Verschiebung des Übertragungskopfes 30 bzw. der Übertragungsmittel 24 zum Zwecke der Justierung des Belichtungsabstandes d wird bei allen Ausführungsformen bevorzugt, so dass eine hohe Auflösung der Datenübertragung und damit eine exzellente Bildqualität resultiert.

Als Übertragungsmittel werden Halbleiter-Laser in Form von Laser-Dioden verwendet. Andere auf der Halbleitertechnik beruhenden Laser, wie z.B. Laser-Transistoren, die zur Bildung von systematischen Verteilungen von Lichtquellen, sogenannten Arrays, eingesetzt werden können sind selbstverständlich ebenfalls vom Erfindungsgedanken erfasst.

Es hat sich als besonders vorteilhaft erwiesen, dass - im Falle der Verwendung von Laserdioden - alle Lasermodule und alle diesen zugeordneten elektrischen Leistungsteile auf dem Übertragungskopf 30 und um die Zylinderachse 29 des Aufnehmers 22, 22' rotierbar angeordnet sind. Diese Anordnung ermöglicht es, die elektrische Energie für den Betrieb der Laserdioden mit hoher Spannung und niedrigen Stromwerten über einen Schleifring auf den Übertragungskopf 30 zu führen und dort, in den elektrischen Leistungsteilen auf dem Übertragungskopf 30, in eine für die Laserdioden optimale niedrige Spannung bei hohem Strom umzuwandeln. Zudem ist es für den Betrieb der Laserdioden besonders vorteilhaft, wenn jede Laserdiode mit je einem Peltier-Element kühlbar verbunden ist, so dass eine konstante Betriebstemperatur eingehalten werden kann. Auf dem Übertragungskopf 30 können 24 bis 256 Laserdioden vorgesehen werden, die ihr Licht an je einen Lichtleiter, welcher so mit je einer Laserdiode zusammenwirkt, abgeben. In einer bevorzugten Ausführungsform sind auf dem Übertragungskopf 64 Laserdioden angeordnet. 64 als Lichtleiter wirkende Glasfaserkabel leiten die 64 individuellen Signale der 64 Laserdioden auf eine am Übertragungskopf 30 angeordnete Optik. Eine besonders bevorzugte Anordnung der Enden dieser Lichtleiter ist ein Array, in welchem diese als Lichtquellen wirkenden Lichtleiterenden in 8 Reihen angeordnet sind; durch diese Anordnung entsteht eine platzmässig optimale Verteilung der Lichtquellen und damit ein Array von 64 Lichtquellen mit einem minimalen Flächenbedarf. Mittels der Optik wird das Array von Lichtquellen auf dem Datenträger 23, 23', insbesondere auf einer Thermoplatte, entsprechend der Intensitätsverteilung der Laserdioden abgebildet. Damit durch Unterschiede in den Intensitätsmaxima der Laserdioden kein sogenanntes "Banding" bzw. ein unerwünschtes Streifenmuster auf dem Datenträger 23, 23' entsteht, kann mit dem erfindungsgemässen System die maximale Intensität jeder Laserdiode und damit auch jeder Lichtquelle vor oder auch während der Datenübertragung gemessen und darauf die maximalen Intensitäten aller Lichtquellen einander angeglichen werden. Dieses Messen und Angleichen kann automatisch erfolgen und hat den Vorteil, dass durch individuelles Altern der Laserdioden hervorgerufene Intensitätsschwankungen rechtzeitig korrigiert werden können.

Die erfindungsgemässe Anordnung (vergl. Fig. 3) ermöglicht zudem den Einsatz von einem oder auch mehreren Feststoff (= Rubidium-Laser) oder Gas-Lasern (= Neon-, YAG-Laser). Der Einsatz dieser Laser umfasst selbstverständlich das Anordnen von speziellen Lichtleitmitteln wie Spiegel und dergleichen.

Ermöglicht wird dieser Einsatz durch eine entsprechend massive und voluminöse Ausbildung des Übertragungskopfes 30.

Vorteile des erfindungsgemässen Übertragens von Daten auf Datenträger bzw. Belichtens von Druckplatten vereinen die Vorteile des Innentrommelkonzeptes (unabhängige Plattengrösse, einfache Beschickung des Belichters, mögliche Automation der Plattenzuführung) mit den Vorteilen des Aussentrommelprinzips (Belichtungsabstand von wenigen Millimetern, Einsatz von Laserdioden), so dass in Mehrstrahltechnik - z.B. mittels Arrays von mit Laserdioden zusammenwirkenden Lichtleitern - ein geringer Abstand der Optik zur Druckplatte realisiert werden kann.

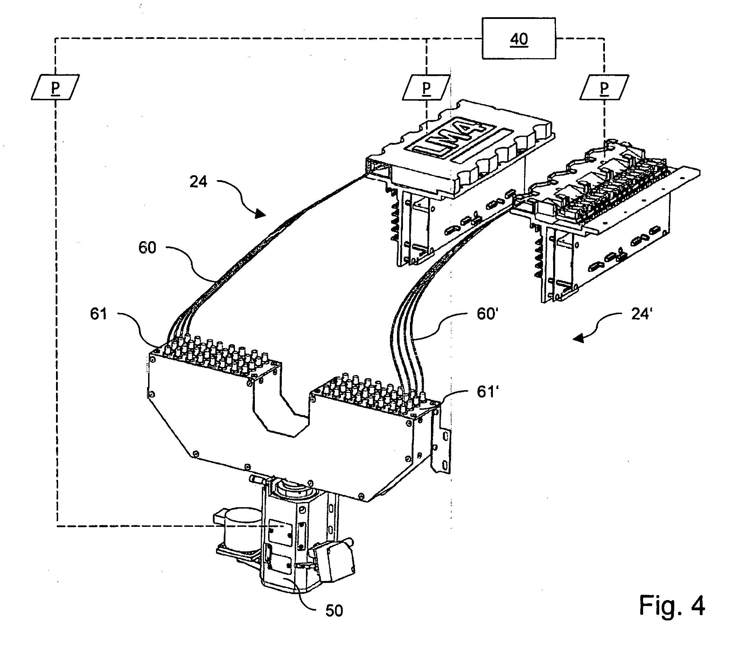

Fig. 4 zeigt eine perspektivische Ansicht von zwei Übertragungsmitteln 24, 24' und einer Optik 50 in einem erfindungsgemässen Innentrommelbelichtungssystem. An ihrem einen Ende sind die Lichtleiter 60, 60' mit rasterförmig auf Verbindungsplatten 61, 61' angeordneten Anschlüssen und an ihrem gegenüberliegenden Ende mit Laserdioden bzw. mit LEDs der Übertragungsmittel 24, 24' verbunden. So stellt hier das Übertragungsmittel 24 Licht mit der Wellenlänge von 405 nm und das Übertragungsmittel 24' Licht mit der Wellenlänge von 830 nm zur Verfügung. Durch die rasterförmige Anordnung der Lichtleiter 60, 60' entsteht ein jeweiliges Array von Lichtquellen einer Wellenlänge.

Die Lichtleiter 60, 60' lassen dabei eine räumliche getrennte Anordnung der Laserdioden und der Lichtquellen zu, welche dadurch problemlos z.B. in einen Übertragungskopf 30 integrierbar sind, wie er in Fig. 3 gezeigt ist. Gleichzeitig kann durch deren entsprechende Positionierung erreicht werden, dass keine Massenunwuchten in dem Kopf 24 auftreten. Über die Optik 50 sind die Arrays aus Lichtquellen jedes Übertragungsmittels auf das zu bearbeitende Material fokussierbar. Eine Steuerung 40 sieht dabei Parametersätze

Eine Steuereinheit 40 lässt dabei ein müheloses Umschalten der Übertragungsmittel 24, 24' von einer auf eine andere Wellenlänge zu, um entsprechende Materialien gezielt zu bearbeiten. Mit den vorstehend genannten Wellenlängen werden insbesondere Siebdruck und Offset-Druckanwendungen abgedeckt. Zur Einstellung der Übertragungsmittel 24, 24' und der Optik 50 sind an der Steuereinheit 40 entsprechende Parametersätze P hinterlegt, welche übermittelt werden, um diese Komponenten auf eine gewünschte Wellenlänge einzustellen. Auch die Bewegung des Übertragungskopfs kann über diese Parametersätze entsprechend eingestellt werden. Durch Multiplikation der Übertragungsmittel 24, 24' und entsprechende Kopplung mit der Optik 50 können natürlich auch noch weitere Wellenlängen zur Verfügung gestellt werden, z.B. 375 nm, 940 nm und 950 nm Wellenlänge. Die Parametersätze P sind dann um entsprechende Betriebsparameter zu erweitern. Die Steuerung 40 ermöglicht in jedem Fall eine hochgradige Automatisierung des hybriden Systems, so dass dessen Handhabung trotz flexibler Einsatzmöglichkeiten deutlich vereinfacht ist.

Die Optik 50 muss dabei nicht notwendigerweise über Parametersätze eingestellt werden, sondern kann auch über eine adaptive Beschichtung verfügen, welche die Fokussierung der unterschiedlichen Wellenlängen ermöglicht. Bevorzugt wird aber eine wellenlängenabhängige Anpassung der Optik 50 z.B. über eine Polymerlinse oder ein DLP, um eine besonders exakte Einstellung - auch auf mehr als zwei - unterschiedliche Wellenlängen vornehmen zu können.

In der vorliegenden Anmeldung wurde auf die exakte Beschreibung technischer Details, wie die Übertragung der Daten auf drehbare Übertragungsmittel (beispielsweise mittels Lichtleitern) die elektrische Kontaktierung mittels Schleifkontakten im Interesse der Kürze der Anmeldung verzichtet. Das Lösen solcher Detailprobleme entspricht selbstverständlich dem Wissen und Können eines mit einer solchen Aufgabe betrauten Fachmanns.

## Patentansprüche

1. System (21) zum Übertragen von Daten auf plattenförmige Datenträger (23, 23'), welches einen zumindest teilweise als Innenzylinder geformten Aufnehmer (22, 22') zum Anordnen der Datenträger - deren zur Aufnahme von Daten vorgesehene Seite der Zylinderachse (29) des Aufnehmers (22, 22') zugewandt ist - und einen um diese Zylinderachse (29) rotierbaren Übertragungskopf (30) mit wenigstens zwei Übertragungsmitteln (24, 24') - zum Übertragen der Daten auf den Datenträger (23) - umfasst, wobei der Aufnehmer (22, 22') und der Übertragungskopf (30) auch in Richtung der Zylinderachse (29) relativ zueinander bewegbar sind, **dadurch gekennzeichnet, dass** die wenigstens zwei Übertragungsmittel (24, 24'), zum Übertragen der Daten in Mehrstrahltechnik, ein jeweiliges Array von Lichtquellen umfassen, wobei sich die Wellenlänge des Arrays von Lichtquellen eines Übertragungsmittels (24) von der Wellenlänge des Arrays von Lichtquellen anderer Übertragungsmittel (24') unterscheidet, dass die Lichtquellen mittels Lichtleitern (60, 60') mit von den Lichtquellen räumlich getrennten Laserdioden optisch leitend verbunden sind, und dass eine Steuereinheit (40) vorgesehen ist, um die Übertragungsmittel (24, 24') zum Erzeugen von Licht unterschiedlicher Wellenlängen wechselweise Ein- bzw. Auszuschalten.

2. System (21) nach Anspruch 1, **dadurch gekennzeichnet, dass** die wenigstens zwei Übertragungsmittel (24, 24') zum Erzeugen von Licht der Wellenlängen 375 nm und/oder 405 nm und/oder 830 nm und/oder 904 nm ausgelegt sind.

3. System (21) nach Anspruch 1 oder 2, **dadurch gekennzeichnet, dass** eine einzige Optik (50) zum Fokussieren der Arrays von Lichtquellen auf den Datenträger (23, 23') vorgesehen ist, welche auf das Licht unterschiedlicher Wellenlängen anpassbar ist.

4. System (21) nach Anspruch 3, **dadurch gekennzeichnet, dass** die Optik (50) ein Spiegelelement mit elektromechanisch verformbarer Oberfläche aufweist.

5. System (21) nach Anspruch 3, **dadurch gekennzeichnet, dass** die Optik (50) ein sphärisch verformbares Linsenelement aufweist.

6. System (21) nach Anspruch 3, **dadurch gekennzeichnet, dass** die Optik (50) ein Linsenelement mit wellenlängenadaptiver Beschichtung aufweist.

7. System (21) nach einem der vorstehenden Ansprüche, **dadurch gekennzeichnet, dass** die Steuereinheit (40) wellenlängenabhängige Parametersätze (P) zum automatischen Einstellen des Systems (21) auf eine gewünschte Wellenlänge umfasst.

8. System (21) nach Anspruch 7, **dadurch gekennzeichnet, dass** die Parametersätze (P) wenigstens Betriebsparameter der Lichtquellen und/oder des Übertragungskopfs (30) und/oder der Übertragungsmittel (24, 24') und/oder der Optik (50) umfassen.

9. System (21) nach einem der vorstehenden Ansprüche, **dadurch gekennzeichnet, dass** eine Distanz (d) zwischen zumindest einer Oberfläche des Übertragungskopfes (30) bzw. der Übertragungsmittel (24, 24') und dem Datenträger (23, 23') - während dem Übertragen von Daten - weniger als 1/4 des Aufnehmerdurchmessers beträgt.

10. System (21) nach einem der vorstehenden Ansprüche, **dadurch gekennzeichnet, dass** die Distanz (d) zwischen zumindest einer Oberfläche des Übertragungskopfes (30) bzw. der Übertragungsmittel (24, 24') und dem Datenträger (23, 23') - während dem Übertragen von Daten - weniger als 1 cm beträgt.

11. System (21) nach einem der vorstehenden Ansprüche, **dadurch gekennzeichnet, dass** der Aufnehmer (22, 22') entlang seiner Zylinderachse (29) bewegbar angeordnet ist.

12. System (21) nach einem der vorstehenden Ansprüche, **dadurch gekennzeichnet, dass** ein elektrischer Linearmotor zum Bewegen des Übertragungskopfs (30) und/oder des Aufnehmers (22, 22') vorgesehen ist.

13. System (21) nach einem der vorhergehenden Ansprüche, **dadurch gekennzeichnet, dass** das Array 16 bis 256 Lichtquellen umfasst.

14. System (21) nach einem der vorhergehenden Ansprüche, **dadurch gekennzeichnet, dass** das Array 64 Lichtquellen umfasst.

15. System (21) nach Anspruch 14, **dadurch gekennzeichnet, dass** die 64 Lichtquellen in 8 Reihen angeordnet sind.

16. System (21) nach einem der Ansprüche 3 bis 15, **dadurch gekennzeichnet, dass** der Übertragungskopf (30) die Optik (50) zum Abbilden des Arrays von Lichtquellen auf den Datenträger (23, 23') umfasst.

17. System (21) nach einem der vorhergehenden Ansprüche, **dadurch gekennzeichnet, dass** die Übertragungsmittel (24, 24') Halbleiter-Laser, insbesondere Laserdioden, umfassen.

18. System (21) nach Anspruch 17, **dadurch gekennzeichnet, dass** die Lichtquellen durch Enden von Lichtleitern (60, 60') gebildet sind, welche mit je einer Laserdiode zusammenwirken.

19. System (21) nach Anspruch 18, **dadurch gekennzeichnet, dass** die Laserdioden und/oder die Übertragungsmittel (24, 24') Anschlüsse zur lösbaren Verbindung der einzelnen Lichtleiter (60, 60') aufweisen.

20. System (21) nach Anspruch 19, **dadurch gekennzeichnet, dass** die Übertragungsmittel (24, 24') eine jeweilige Verbindungsplatte (61, 61') mit rasterförmig darauf angeordneten Anschlüssen aufweisen.

21. System (21) nach Anspruch 19 oder 20, **dadurch gekennzeichnet, dass** jede Laserdiode mit je einem Peltier-Element kühlbar verbunden ist.

22. System (21) nach einem der Ansprüche 19 bis 21, **dadurch gekennzeichnet, dass** alle Lasermodule und alle diesen zugeordneten elektrischen Leistungsteile auf dem Übertragungskopf (30) und um die Zylinderachse (29) des Aufnehmers (22,22') rotierbar angeordnet sind.

23. Verfahren zum Übertragen von Daten unter Verwendung eines Systems nach einem der vorstehenden Ansprüche, **dadurch gekennzeichnet, dass** die Daten in Mehrstrahltechnik auf einen Datenträger (23, 23') übertragen werden, und abhängig von einer jeweils geforderten Wellenlänge des Lichts jeweils andere Lichtquellen ein- bzw. ausgeschaltet werden.

24. Verfahren nach Anspruch 23, **dadurch gekennzeichnet, dass** abhängig von einer jeweils gewünschten Wellenlänge eine automatische Einstellung des Systems (21) über dazu hinterlegte Parametersätze (P) vorgenommen wird.

25. Verfahren nach Anspruch 23 oder 24, **dadurch gekennzeichnet, dass** wenigstens eine Einstellung von Betriebsparametern der Lichtquellen und/oder des Übertragungskopfs (30) und/oder der Übertragungsmittel (24, 24') und/oder einer Optik (50) vorgenommen wird.

26. Verfahren nach einem der Ansprüche 23 bis 25, **dadurch gekennzeichnet, dass** eine Druckplatte oder eine Flexoplatte oder eine Siebdruckschablone oder eine Buchdruckplatte (23, 23') belichtet wird.

27. Verfahren nach einem der Ansprüche 23 bis 26, **dadurch gekennzeichnet, dass** die maximale Intensität jeder Lichtquelle vor oder während der Datenübertragung individuell gemessen wird.

28. Verfahren nach Anspruch 27, **dadurch gekennzeichnet, dass** - zum Vermeiden eines Streifenmusters - die maximalen Intensitäten aller Lichtquellen einander angeglichen werden.

29. Verwendung eines Systems (21) nach einem der Ansprüche 1 bis 22 zum Belichten von Druckplatten, Flexoplatten, Siebdruckschablonen oder Buchdruckplatten (23, 23').

## Claims

1. A system (21) for transferring data to plate-like data storage media (23, 23'), which system comprises a pick-up (22, 22') which is at least partially in the form of an inner cylinder and is intended to arrange the data storage media - the side of which that is intended to receive data faces the cylinder axis (29) of the pick-up (22, 22') - and a transfer head (30) which can be rotated about this cylinder axis (29) and has at least two transfer means (24, 24') for transferring the data to the data storage medium (23), wherein the pick-up (22, 22') and the transfer head (30) can also be moved relative to one another in the direction of the cylinder axis (29), **characterised in that** the at least two transfer means (24, 24') comprise a respective array of light sources in order to transfer the data using multi-beam technology, wherein the wavelength of the array of light sources of a transfer means (24) differs from the wavelength of the array of light sources of other transfer means (24'), that the light sources have an optically conductive connection to laser diodes spatially separate from the light sources by means of light conductors (60, 60') and that a control unit (40) is provided in order to alternately switch the transfer means (24, 24') on and off for the purpose of generating light at different wavelengths.

2. The system (21) according to claim 1, **characterised in that** the at least two transfer means (24, 24') are designed to generate light with wavelengths of 375 nm and/or 405 nm and/or 830 nm and/or 904 nm.

3. The system (21) according to claim 1 or 2, **characterised in that** a single optical system (50) is provided to focus the arrays of light sources onto the data storage medium (23, 23'), which can be adapted to light at different wavelengths.

4. The system (21) according to claim 3, **characterised in that** the optical system (50) exhibits a reflective element with an electromechanically deformable surface.

5. The system (21) according to claim 3, **characterised in that** the optical system (50) exhibits a spherically deformable lens element.

6. The system (21) according to claim 3, **characterised in that** the optical system (50) exhibits a lens element with a wavelength-adaptive coating.

7. The system (21) according to one of the preceding claims, **characterised in that** the control unit (40) comprises wavelength-dependent parameter sets (P) for the automatic adjustment of the system (21) to a desired wavelength.

8. The system (21) according to claim 7, **characterised in that** the parameter sets (P) comprise at least operating parameters of the light sources and/or of the transfer head (30) and/or of the transfer means (24, 24') and/or of the optical system (50).

9. The system (21) according to one of the preceding claims, **characterised in that** a distance (d) between at least one surface of the transfer head (30) or else the transfer means (24, 24') and the data storage medium (23, 23') - during the transfer of data - is less than ¼ of the pick-up diameter.

10. The system (21) according to one of the preceding claims, **characterised in that** the distance (d) between at least one surface of the transfer head (30) or else the transfer means (24, 24') and the data storage medium (23, 23') - during the transfer of data - is less than 1 cm.

11. The system (21) according to one of the preceding claims, **characterised in that** the pick-up (22, 22') is movably disposed along its cylinder axis (29).

12. The system (21) according to one of the preceding claims, **characterised in that** an electric linear motor is provided to move the transfer head (30) and/or the pick-up (22, 22').

13. The system (21) according to one of the preceding claims, **characterised in that** the array comprises 16 to 256 light sources.

14. The system (21) according to one of the preceding claims, **characterised in that** the array comprises 64 light sources.

15. The system (21) according to claim 14, **characterised in that** the 64 light sources are disposed in 8 rows.

16. The system (21) according to one of claims 3 to 15, **characterised in that** the transfer head (30) comprises the optical system (50) for displaying the array of light sources on the data storage medium (23, 23').

17. The system (21) according to one of the preceding claims, **characterised in that** the transfer means (24, 24') comprise semiconductor lasers, in particular laser diodes.

18. The system (21) according to claim 17, **characterised in that** the light sources are formed by the ends of light conductors (60, 60'), each of which interacts with a laser diode.

19. The system (21) according to claim 18, **characterised in that** the laser diodes and/or the transfer means (24, 24') have attachments for the detachable connection of the individual light conductors (60, 60').

20. The system (21) according to claim 19, **characterised in that** the transfer means (24, 24') each feature a connection plate (61, 61') with connections disposed on it in grid form.

21. The system (21) according to claim 19 or 20, **characterised in that** each laser diode is connected to a Peltier element such that it can be cooled.

22. The system (21) according to one of the claims 19 to 21, **characterised in that** all laser modules and all electrical power units assigned to these are rotatably disposed on the transfer head (30) and about the cylinder axis (29) of the pick-up (22, 22').

23. A method of transferring data using a system according to one of the preceding claims, **characterised in that** the data are transferred to a data storage medium (23, 23') using multi-beam technology and other light sources are switched on and off in each case, depending on the wavelength of the light required in each case.

24. The method according to claim 23, **characterised in that** an automatic system setting (21) is made via parameter sets (P) stored for this purpose, depending on a wavelength required in each case.

25. The method according to claim 23 or 24, **characterised in that** at least one setting of operating parameters of the light sources and/or the transfer head (30) and/or the transfer means (24, 24') and/or an optical system (50) is performed.

26. The method according to one of the claims 23 to 25, **characterised in that** a printing plate or a flexo plate or a screen printing template or a letterpress printing plate (23, 23') is exposed.

27. The method according to one of the claims 23 to 26, **characterised in that** the maximum intensity of each light source is individually measured before or during the data transfer.

28. The method according to claim 27, **characterised in that** the maximum intensities of all light sources are equalised to one another to avoid banding.

29. The use of a system (21) according to one of the claims 1 to 22 to expose printing plates, flexo plates, screen printing templates or letterpress printing plates (23, 23').

## Revendications

1. Système (21) pour la transmission de données sur des supports de données (23, 23') en forme de plaques, lequel comprend un dispositif de réception (22, 22') formé au moins en partie en tant que cylindre intérieur pour disposer les supports de données - dont la face prévue pour réceptionner des données est tournée vers l'axe de cylindre (29) du dispositif de réception (22, 22') - et une tête de transmission (30) pouvant tourner autour de cet axe de cylindre (29) avec au moins deux moyens de transmission (24, 24') - pour la transmission des données sur le support de données (23) - moyennant quoi le dispositif de réception (22, 22') et la tête de transmission (30) peuvent se mouvoir l'un par rapport à l'autre également en direction de l'axe de cylindre (29), **caractérisé en ce que** ces au moins deux moyens de transmission (24, 24') comprennent, pour la transmission des données selon la technique à faisceaux multiples, un réseau de sources lumineuses respectif, la longueur d'onde du réseau de sources lumineuses d'un moyen de transmission (24) divergeant de la longueur d'onde du réseau de sources lumineuses d'autres moyens de transmission (24'), **en ce que** les sources lumineuses sont reliées à l'aide de conducteurs de lumière (60, 60') de manière optiquement conductrice à des diodes laser séparées spatialement des sources lumineuses, et **en ce qu'**une unité de commande (40) est prévue, afin d'allumer et d'éteindre en alternance les moyens de transmission (24, 24') pour générer de la lumière de différentes longueurs d'ondes.

2. Système (21) selon la revendication 1, **caractérisé en ce que** ces au moins deux moyens de transmission (24, 24') sont étudiés pour générer de la lumière des longueurs d'ondes de 375 nm et/ou 405 nm et/ou 830 nm et/ou 904 nm.

3. Système (21) selon les revendications 1 ou 2, **caractérisé en ce qu'**un seul dispositif optique (50) est prévu pour la focalisation des réseaux de sources lumineuses sur le support de données (23, 23'), lequel peut être adapté à la lumière de différentes longueurs d'ondes.

4. Système (21) selon la revendication 3, **caractérisé en ce que** le dispositif optique (50) présente un élément de miroir avec une surface déformable électro-mécaniquement.

5. Système (21) selon la revendication 3, **caractérisé en ce que** le dispositif optique (50) présente un élément de lentille déformable sphériquement.

6. Système (21) selon la revendication 3, **caractérisé en ce que** le dispositif optique (50) présente un élément de lentille avec un revêtement d'adaptation aux longueurs d'ondes.

7. Système (21) selon l'une des revendications précédentes, **caractérisé en ce que** l'unité de commande (40) comprend des jeux de paramètres (P) dépendant des longueurs d'ondes pour le réglage automatique du système (21) à une longueur d'onde souhaitée.

8. Système (21) selon la revendication 7, **caractérisé en ce que** les jeux de paramètres (P) comprennent au moins des paramètres d'exploitation des sources lumineuses et/ou de la tête de transmission (30) et/ou des moyens de transmission (24, 24') et/ou du dispositif optique (50).

9. Système (21) selon l'une des revendications précédentes, **caractérisé en ce qu'**une distance (d) entre au moins une surface de la tête de transmission (30) ou des moyens de transmission (24, 24') et le support de données (23, 23') est de moins de ¼ du diamètre du dispositif de réception pendant la transmission de données.

10. Système (21) selon l'une des revendications précédentes, **caractérisé en ce que** la distance (d) entre au moins une surface de la tête de transmission (30) ou les moyens de transmission (24, 24') et le support de données (23, 23') est inférieure à 1 cm pendant le transfert des données.

11. Système (21) selon l'une des revendications précédentes, **caractérisé en ce que** le dispositif de réception (22, 22') est disposé de manière mobile le long de son axe de cylindre (29).

12. Système (21) selon l'une des revendications précédentes, **caractérisé en ce que** l'on prévoit un moteur linéaire électrique pour déplacer la tête de transmission (30) et/ou le dispositif de réception (22, 22').

13. Système (21) selon l'une des revendications précédentes, **caractérisé en ce que** le réseau 16 comprend jusqu'à 256 sources lumineuses.

14. Système (21) selon l'une des revendications précédentes, **caractérisé en ce que** le réseau comprend 64 sources lumineuses.

15. Système (21) selon la revendication 14, **caractérisé en ce que** les 64 sources lumineuses sont disposées en 8 rangées.

16. Système (21) selon l'une des revendications 3 à 15, **caractérisé en ce que** la tête de transmission (30) comprend le dispositif optique (50) pour représenter le réseau de sources lumineuses sur les supports de données (23, 23').

17. Système (21) selon l'une des revendications précédentes, **caractérisé en ce que** les moyens de transmission (24, 24') comprennent des lasers à semi-conducteurs, en particulier des diodes laser.

18. Système (21) selon la revendication 17, **caractérisé en ce que** les sources lumineuses sont formées par des extrémités de conducteurs de lumière (60, 60') lesquelles coopèrent respectivement avec une diode laser.

19. Système (21) selon la revendication 18, **caractérisé en ce que** les diodes laser et/ou les moyens de transmission (24, 24') présentent des bornes pour la liaison détachable des conducteurs de lumière (60, 60') individuels.

20. Système (21) selon la revendication 19, **caractérisé en ce que** les moyens de transmission (24, 24') présentent une plaque de liaison (61, 61') respective avec des bornes disposées en forme de quadrillage dessus.

21. Système (21) selon les revendications 19 ou 20, **caractérisé en ce que** chaque diode laser est en liaison de manière réfrigérante avec respectivement un élément de Peltier.

22. Système (21) selon l'une des revendications 19 à 21, **caractérisé en ce que** tous les modules laser et toutes les pièces de puissance électrique associées à ceux-ci sont disposés de manière rotative sur la tête de transmission (30) et autour de l'axe de cylindre (29) du dispositif de réception (22, 22').

23. Procédé pour la transmission de données en utilisant un système selon l'une des revendications précédentes, **caractérisé en ce que** les données sont transmises sur un support de données (23, 23') selon une technique à faisceaux multiples, et **en ce qu'**en fonction d'une longueur d'onde respectivement nécessaire de la lumière, respectivement d'autres sources de lumière sont allumées ou éteintes.

24. Procédé selon la revendication 23, **caractérisé en ce qu'**en fonction d'une longueur d'onde respectivement souhaitée, on procède à un réglage automatique du système (21) via des jeux de paramètres (P) déposés à cet effet.

25. Procédé selon les revendications 23 ou 24, **caractérisé en ce qu'**au moins un réglage de paramètres d'exploitation des sources lumineuses et/ou de la tête de transmission (30) et/ou des moyens de transmission (24, 24') et/ou d'un dispositif optique (50) est réalisé.

26. Procédé selon l'une des revendications 23 à 25, **caractérisé en ce qu'**une plaque d'impression ou une plaque flexographique ou un pochoir ou une plaque d'impression de typographie (23, 23') est exposée.

27. Procédé selon l'une des revendications 23 à 26, **caractérisé en ce que** l'intensité maximale de chaque source lumineuse est mesurée individuellement avant ou pendant la transmission de données.

28. Procédé selon la revendication 27, **caractérisé en ce que**, pour éviter un motif à rayures, les intensités maximales de toutes les sources lumineuses sont harmonisées entre elles.

29. Utilisation d'un système (21) selon l'une des revendications 1 à 22 pour l'exposition de plaques d'impression, de plaques flexographiques, de pochoirs ou de plaques d'impression de typographie (23, 23').
